# EUROPÄISCHE PATENTSCHRIFT

(11) **EP 1 662 625 B1**
(45) Veröffentlichungstag und Bekanntmachung des Hinweises auf die Patenterteilung: **24.10.2007**
(21) Anmeldenummer: 05025618.9
(22) Anmeldetag: 24.11.2005
(51) Int. Cl.: H01S 5/042, G11B 7/125, G06K 15/12, H04B 10/155

(54) **Treiberschaltung mit selbständiger Offsetkompensation eines Verstärkers und Verfahren zur Offsetkompensation eines Verstärkers einer Treiberschaltung**
Driver circuit having an amplifier with automatic offset compensation and method of offset compensation of an amplifier comprised in a driver circuit
Circuit d'excitation comprenant un amplificateur avec compensation automatique de courants de décalage et méthode de compensation de courants de décalage d'un amplificateur compris dans un circuit d'excitation

(30) Priorität: 26.11.2004 DE 102004058595
(43) Veröffentlichungstag der Anmeldung: 31.05.2006
(73) Patentinhaber: ATMEL Germany GmbH, 74072 Heilbronn (DE)
(72) Erfinder: Gropper, Karl-Josef, Dipl.-Ing., 89250 Senden (DE); Knotz, Herbert, Ing., 89155 Erbach (DE); Offenwanger, Michael, 89331 Burgau (DE); Prohaska, Armin, Dr., 89073 Ulm (DE)

(56) Entgegenhaltungen:
- WO-A-20/04040721
- US-A1- 2003 201 950
- US-B1- 6 392 215
- US-B1- 6 549 265
- US-B1- 6 778 784

## Beschreibung

Die Erfindung betrifft eine Treiberschaltung, die in einem Betriebsmodus ein Bauteil treibt, das nur dann eine Ausgangsleistung liefert, wenn ein treibendes Eingangssignal einen ersten Schwellenwert übersteigt, mit einem Differenzverstärker, dessen Ausgangssignal das treibende Eingangssignal steuert, einem Referenzsignalgenerator, der einen Referenzsignaleingang des Differenzverstärkers speist, und einer äußeren Rückführung, die ein vom Ausgangssignal abhängiges Signal an einen Rückführsignaleingang des Differenzverstärkers legt.

Die Erfindung betrifft ferner ein Verfahren zur Kompensation von Offsetströmen in einer solchen Treiberschaltung.

Aus US 6 778 784 B1 ist eine optische Sendeeinrichtung bekannt. Die Sendeeinrichtung umfaßt mindestens einen Lasersender, der in Abhängigkeit von zu sendenden binären Datensignalen Licht aussendet, und einen Monitorempfänger, der einen Teil des ausgesendeten Lichts empfängt und in einen Monitorstrom umwandelt. Eine Regelschaltung regelt die mittlere optische Ausgangsleistung des Lasersenders gemäß einem Gleichstrom-Vorgabewert unter Auswertung des Monitorstromes konstant, wobei der Vorgabewert durch Abgleich gewonnen ist und in einen Festwertspeicher im Zuge des Abgleichs permanent abgespeichert ist.

Ein typisches Beispiel eines eingangs genannten Bauteils ist eine Laserdiode, bei der ein Lasereffekt erst oberhalb einer Laserschwelle eintritt. Bei einer Laserdiode erfolgt die äußere Rückführung über die abgestrahlte Lichtleistung der Laserdiode und eine Photodiode, die an den Rückführsignaleingang angeschlossen ist und einen Teil der abgestrahlten Lichtleistung empfängt. Wenn die Laserdiode vergleichsweise viel Lichtleistung abstrahlt, liefert die Photodiode einen hohen Photostrom an den Rückführsignaleingang des Differenzverstärkers. Dadurch wird die Differenz am Eingang des Differenzverstärkers verkleinert, was das Ausgangssignal des Differenzverstärkers verkleinert und damit die Lichtleistung der Laserdiode verringert. Entsprechend führt eine vergleichsweise geringe abgestrahlte Lichtleistung zu einer Vergrößerung der Differenz und damit zu einer Vergrößerung der Lichtleistung. Die Rückführung schließt damit einen Regelkreis, durch den sich im eingeschwungenen Zustand eine stabile Lichtleistung bei stabiler Eingangssignaldifferenz einstellt.

Dabei stellt sich zwischen Referenzsignaleingang und Rückführsignalseingang eine Signaldifferenz ein, die dem Quotienten aus Ausgangssignal und Verstärkungsfaktor des Differenzverstärkers entspricht.

Ideale Differenzverstärker liefern bei bestimmten Referenzsignalwerten reproduzierbar gleiche Ausgangssignale und besitzen damit eine reproduzierbar stabile Kennlinie. Bei realen Differenzverstärkern treten jedoch Verschiebungen der Kennlinien durch Offsetströme der Differenzverstärker auf. Die Offsetströme sind in einem Ersatzschaltbild als additiver Offset des Referenzsignals darstellbar.

Bei einer Treiberschaltung mit einem Differenzverstärker, der einen solchen Offset aufweist, stellt sich daher am Referenzsignaleingang eine Signalverfälschung ein. Ohne Gegenmaßnahmen wird eine solche Signalverfälschung von der äußeren Rückführung stabilisiert. Bei abgeschaltetem Referenzsignal wirkt der Offsetstrom im Ersatzschaltbild allein als Referenzsignal. Die äußere Rückführung stellt dann unter Umständen, nämlich wenn die Laserschwelle überschritten wird, eine endliche Ausgangsleistung ein, obwohl der abgeschaltete Referenzsignalgenerator die Ausgangsleistung ebenfalls auf den Wert Null verringern sollte.

Ein solches Verhalten ist daher immer dann störend, wenn kleine Ausgangsleistungen eingestellt werden sollen, wie es zum Beispiel bei einer Laserdiode in einem CD oder DVD Gerät im Lesebetrieb der Fall ist.

Vor diesem Hintergrund besteht die Aufgabe der Erfindung in der Angabe einer verbesserten Treiberschaltung, bei der Offsetströme des Differenzverstärkers kompensiert werden.

Diese Aufgabe wird bei einem Verfahren der eingangs genannten Art dadurch gelöst, dass die Treiberschaltung eine Adaptionsschaltung und eine alternativ zur äußeren Rückführung in einem Abgleichmodus aktivierbare innere Rückführung aufweist, die bereits bei Eingangssignalen, die den ersten Schwellenwert nicht überschreiten, ein Signal sowohl an den Rückführsignaleingang als auch an die Adaptionsschaltung liefert, die Adaptionsschaltung aus dem Signal ein Kompensationssignal bildet und speichert, das ein am Referenzeingang bei abgeschaltetem Referenzsignalgenerator allein wirksames Offsetsignal kompensiert, und die Adaptionsschaltung das gespeicherte Kompensationssignal bei aktivierter äußerer Rückführung zusätzlich zu einem vom Referenzsignalgenerator gelieferten Referenzsignal in den Referenzeingang, oder in den Rückführsignaleingang einspeist.

Ferner wird diese Aufgabe bei einem Verfahren der eingangs genannten Art durch die folgenden Schritte gelöst: Aktivieren einer alternativ zur äußeren Rückführung aktivierbaren inneren Rückführung, die bereits bei Eingangssignalen, die den ersten Schwellenwert nicht überschreiten, ein Signal sowohl an den Rückführsignaleingang als auch an die Adaptionsschaltung liefert, Speichern eines aus dem Signal gebildeten Kompensationssignals, das ein am Referenzeingang bei abgeschaltetem Referenzsignalgenerator allein wirksames Offsetsignal kompensiert, und, bei aktivierter äußerer Rückführung, zusätzlich zur Einspeisung eines vom Referenzsignalgenerator gelieferten Referenzsignals erfolgendes Einspeisen des gespeicherten Kompensationssignals in den Referenzeingang, oder in den Rückführsignaleingang.

Durch diese Merkmale wird die Aufgabe der Erfindung gelöst.

Im Abgleichmodus bei abgeschaltetem Referenzsignalgenerator und deaktivierter äußerer Rückführung kann ein erfasstes Rückführsignal eindeutig einem unerwünschten Offsetstrom des Differenzverstärkers zugeordnet werden. Die Bildung und Speicherung eines Kompensationssignals in dem Abgleichmodus führt zusammen mit der zusätzlichen Einspeisung des Kompensationssignals in dem Betriebsmodus zu der gewünschten Kompensation störender Offsetströme.

Mit Blick auf Ausgestaltungen der Treiberschaltung ist bevorzugt, dass die innere Rückführung einen Schwellenwertfilter aufweist, das nur Rückführsignale passieren, lässt, die einen zweiten Schwellenwert überschreiten.

Durch diese Ausgestaltung erfolgt der Adaptionsvorgang bei Ausgangssignalen des Differenzverstärkers, die zu den Rückführsignalen einer durch den zweiten Schwellenwert bestimmten Mindeststärke führen. Als Folge lassen sich die oberhalb des zweiten aber unterhalb des ersten Schwellenwertes im Abgleichmodus ermittelten Kompensationswerte besser auf den späteren Betriebsmodus übertragen als dies bei einer Adaption mit beliebig kleinen Ausgangssignalen des Differenzverstärkers der Fall wäre.

Eine weitere bevorzugte Ausgestaltung zeichnet sich durch eine Realisierung des Schwellenwertfilters als mit der inneren Rückführung verbundene Stromquelle aus, die einen Strom bis zu einer vorbestimmten, dem zweiten Schwellenwert entsprechenden maximalen Stromstärke aufnimmt oder ausgibt.

Diese Ausgestaltung stellt eine besonders einfache und kontinuierliche Form der Schwellenwertfilterung dar die Stromquelle kann z.B. als Quelle negativer Ströme, also als Stromsenke, realisiert sein, die an die innere Rückführung angeschlossen ist und kleine Ströme aufnimmt und nur den über ihren Maximalstrom hinausgehenden Strom in der Rückführung vorbeilässt.

Bevorzugt ist auch, dass die innere Rückführung eine Auskoppelschaltung aufweist, die ein Rückführsignal aus der inneren Rückführung auskoppelt und der Adaptionsschaltung zuführt.

Durch eine solche parallel zur Weiterführung des Rückführsignals in der inneren Rückführung erfolgende Auskopplung kann die Adaption im Gegensatz zu einer Umschaltung, die das Rückführsignal zeitweise zur Adaptionsschaltung und zeitweise zum Rückführsignaleingang des Differenzverstärkers führt, im Abgleichmodus kontinuierlich und ohne störende Beeinflussung der Schleife aus Differenzverstärker und innerer Rückführung erfolgen.

Ferner ist bevorzugt, dass die Auskoppelschaltung einen Stromspiegel aufweist, der einen aus dem Differenzverstärker in die innere Rückführung eingespeisten Strom sowohl in einen zum Rückführsignaleingang führenden Stromzweig als auch in einen Messzweig der Adaptionsschaltung abbildet.

Die Auskopplung mit dem Stromspiegel hat den Vorteil, dass sich durch Anzahl und Dimensionierung der verwendeten Elemente beliebige Übersetzungsverhältnisse zwischen den Strömen in verschiedenen Zweigen des Stromspiegels einstellen lassen. Daher kann zum Beispiel die Dämpfung der Signalrückführung eingestellt werden.

Bevorzugt ist auch, dass die Adaptionsschaltung einen Detektor aufweist, der eine Signalstärke des ausgekoppelten Rückführsignals erfasst und an eine Steuerung übergibt.

Die Signalstärke des Rückführsignals ist ein Maß für die Stärke des Offsetstroms. Daher erlaubt diese Ausgestaltung eine indirekte Messung des Offsetstroms.

Ferner ist bevorzugt, dass der Detektor die Signalstärke periodisch abtastet.

Durch die periodische Abtastung wird eine Folge diskreter Messwerte erzeugt, die in der nachfolgenden Steuerung einfach zu schrittweise erfolgenden Veränderungen eines Kompensationssignals verarbeitet werden können.

Bevorzugt ist auch, dass der Detektor als getakteter Komparator ausgeführt ist, weil dieser eine sehr hohe Empfindlichkeit besitzt. Dies erlaubt eine Minimierung der Wechselwirkung des Messeingriffs mit der inneren Rückführung.

Eine weitere bevorzugte Ausgestaltung zeichnet sich dadurch aus, dass die Steuerung die Signalstärke speichert und über Ansteuerung einer Kompensationsstromquelle einen Kompensationsstrom an dem Referenzeingang erzeugt, der den Offsetstrom wenigstens teilweise kompensiert.

Durch diese Ausgestaltung wird der passende Wert des Kompensationsstroms sukzessive ermittelt, weil eine anfänglich teilweise erfolgende Kompensation, die im Abgleichmodus noch nicht zu einer Veränderung des Rückführsignals führt, gespeichert wird und damit als Basis für eine weitere Veränderung des Kompensationsstroms dienen kann.

Mit Blick auf Ausgestaltungen des Verfahrens ist daher bevorzugt, dass eine Bildung des Kompensationssignals schrittweise erfolgt, wobei das an die Adaptionsschaltung gelieferte Signal mit einem dritten Schwellenwert verglichen wird und wobei das Kompensationssignal von einem Startwert an schrittweise verändert wird, bis das an die Adaptionsschaltung gelieferte Signal den dritten Schwellenwert durchläuft.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: eine bekannte Anordnung einer Treiberschaltung mit einer äußeren Rückführung;
- Fig. 2: eine Kennlinie einer Laserdiode;
- Fig. 3: Kennlinien eines Differenzverstärkers ohne und mit Offsetströmen verschiedenen Vorzeichens;
- Fig.4: ein Blockschaltbild eines Ausführungsbeispiels einer erfindungsgemäßen Treiberschaltung;
- Fig. 5: einen Schaltplan als Beispiel möglicher schaltungstechnischer Realisierungen verschiedener Blöcke aus der Fig. 4;
- Fig. 6: zeitliche Verläufe von Signalen, wie sie beim Ablauf eines Ausführungsbeispiels erfindungsgemäßer Verfahren im Blockschaltbild der Fig. 4 auftreten.

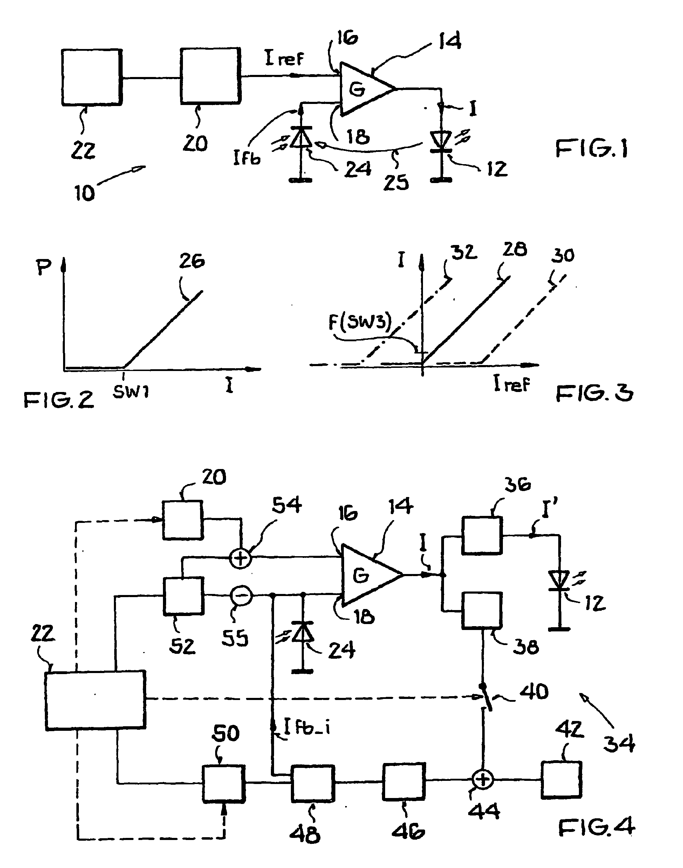

Figur 1 zeigt eine bekannte Treiberschaltung 10, die eine Laserdiode 12 treibt. Die Treiberschaltung 10 besitzt einen Differenzverstärker 14, der einen Referenzsignaleingang 16 und einen Rückführsignaleingang 18 aufweist sowie einen Referenzsignalgenerator 20, eine Steuerung 22 und eine Fotodiode 24. Der Referenzsignaleingang 16 wird von dem Referenzsignalgenerator 20 gespeist, der durch die Steuerung 22 gesteuert wird. An den Rückführsignaleingang 18 ist die Fotodiode 24 angeschlossen, die im Betrieb der Treiberschaltung 10 und der Laserdiode 12 einen Teil der von der Laserdiode 12 abgestrahlten Lichtleistung durch eine optische Kopplung 25 empfängt und in einen Fotostrom umwandelt. Der Fotostrom dient als Rückführsignal Ifb. Der Differenzverstärker 14 stellt einen Strom I als Steuersignal für die Laserdiode 12 bereit, der vom Verstärkungsfaktor G und der Differenz der Signale am Referenzsignaleingang 16 und Rückführsignaleingang 18 abhängt. Auf diese Weise wird die von der Laserdiode 12 abgestrahlte Leistung und die Signalform des optischen Ausgangssignals von dem Referenzsignalgenerator 20 und der Steuerung 22 bestimmt und in einer äußeren Rückführung, die über die optische Kopplung 25 zwischen der Laserdiode 12 und der Fotodiode 24 geschlossen wird, geregelt.

Figur 2 zeigt eine Kennlinie 26 der Laserdiode 12. Dabei ist die Lichtleistung P der Laserdiode über dem treibenden Eingangssignal I aufgetragen. Wie aus dem Verlauf der Kennlinie 26 ersichtlich ist, tritt eine Lichtleistung P erst dann auf, wenn das treibende Eingangssignal I einen Schwellenwert SW1 überschreitet. Dieser Schwellenwert SW1 korrespondiert im Fall der Laserdiode 12 mit der Laserschwelle, die für das Eintreten eines Lasereffektes überschritten werden muss. Die Laserdiode 12 stellt damit ein Beispiel eines Bauteils dar, das nur dann eine Ausgangsleistung P liefert, wenn ein treibendes Eingangssignal I einen ersten Schwellenwert SW1 überschreitet.

Die Figur 3 zeigt typische Kennlinien eines Differenzverstärkers, bspw. des Differenzverstärkers 14 aus der Figur 1. Dabei ist das Ausgangssignal I des Differenzverstärkers 14 über dem Referenzsignal Iref aufgetragen, wobei die Kennlinien mit geöffneter Schleife, also mit konstantem Signal am Rückführsignaleingang 18 aufgenommen worden sind. Das Ausgangssignal I des Differenzverstärkers 14, das in der Figur 3 an der Ordinate aufgetragen ist, bildet zum Beispiel das treibende Eingangssignal I für die Laserdiode 12, das in der Figur 2 längs der Abszisse aufgetragen ist. Figur 3 zeigt insgesamt drei Kennlinien 28, 30 und 32, wobei die Ziffer 28 eine Idealkennlinie bezeichnet. Die Idealkennlinie 28 zeichnet sich dadurch aus, dass sie ohne Offsetstrom durch den Koordinatenursprung geht, so dass bereits eine kleine, von null abweichende Änderung des Referenzsignals Iref eine endliche Änderung des Ausgangssignals I zur Folge hat.

Wie bereits eingangs erwähnt, weisen reale Differenzverstärker jedoch Offsetströme auf, die in einem Ersatzschaltbild als additive Einflüsse auf das Signal am Referenzeingang dargestellt werden können, wobei die additiven Einflüsse sowohl positiv als auch negativ sein können. Die gestrichelt dargestellte Kennlinie 30 geht aus der Idealkennlinie 28 durch eine Verschiebung nach rechts hervor, was einem negativen Offsetstrom entspricht: Wenn man die Idealkennlinie 28 als Funktion von Iref betrachtet, so ist die Kennlinie 30 als gleiche Funktion mit dem Argument (Iref - Ioff) zu bilden, wobei Ioff dem Offsetstrom entspricht. Analog entspricht die durch Verschiebung der Idealkennlinie 28 nach links entstandene Kennlinie 32 einem positiven Offsetstrom, der sich in einer Funktionsdarstellung als positiver Offset in einem Argument Iref + Ioff darstellen lassen würde.

Figur 4 zeigt ein Blockschaltbild eines Ausführungsbeispiels einer erfindungsgemäßen Treiberschaltung 34, mit der sich sowohl die positiven als auch die negativen Offsets der Kennlinien 32 und 30 gegenüber der Idealkennlinie 28 in einem speziellen Abgleichmodus adaptieren lassen, wodurch auch im normalen Betriebsmodus eine Kompensation der Verschiebungen erfolgen kann. Die Treiberschaltung 34 basiert auf der bekannten Treiberschaltung 10 aus der Figur 1 und weist daher u. a. eine Laserdiode 12, einen Differenzverstärker 14 mit Referenzsignaleingang 16 und Rückführsignaleingang 18, einen Referenzsignalgenerator 20, eine Steuerung 22 und eine Fotodiode 24 auf, die an den Rückführsignaleingang 18 des Differenzverstärkers 14 angeschlossen ist.

Zusätzlich zu diesen Elementen weist die Treiberschaltung 34 noch eine Ausgangsstufe 36, einen Schalter 40, ein Schwellenwertfilter 42, eine Schwellenwertverknüpfung 44, eine Dämpfung 46, eine Auskoppelschaltung 48, einen Detektor 50, eine Kompensationsstromquelle 52 und eine Verknüpfung 54 und/oder eine Verknüpfung 55 auf. Dabei dient die Ausgangsstufe 36 lediglich zur weiteren Verstärkung des Ausgangssignals I des Differenzverstärkers 14 zu einem Eingangssignal I' der Laserdiode 12. Die Auskopplung 38 dient zum Auskoppeln eines Rückführsignals, das in einem Abgleichmodus über eine innere Rückführung an den Rückführsignaleingang 18 des Differenzverstärkers 14 geführt wird. Die innere Rückführung wird über ein Schließen des Schalters 40 aktiviert und besteht im Wesentlichen aus dem Schwellenwertfilter 42, der Schwellenwertverknüpfung 44, der Dämpfung 46 und der Auskoppelschaltung 48.

Dabei gibt das Schwellenwertfilter 42 einen zweiten Schwellenwert SW2 für die Regelung über die innere Rückführung vor, der kleiner ist als der in der äußeren Rückführung wirksame erste Schwellenwert SW1, der z. B. der Laserschwelle der Laserdiode 12 entspricht. Die Steuerung 22 schaltet die Treiberschaltung 34 durch Schließen des Schalters 40 in einen Abgleichmodus. Das über die Auskopplung 38 in die innere Rückführung eingekoppelte Ausgangssignal I des Differenzverstärkers 14 wird in der Verknüpfung 44 mit dem vergleichsweise niedrigen zweiten Schwellenwert SW2 des Schwellenwertfilters 42 verknüpft. Dabei kann die Verknüpfung z. B. so geschehen, dass das Schwellenwertfilter 42 einen Strom bis zu einem vorgegebenen Maximalwert von der Verknüpfung 44 ziehen kann, so dass die Verknüpfung 44 nur dann ein Signal an die Dämpfung 46 weitergibt, wenn der durch das Schwellenwertfilter 42 vorgegebene Maximalwert durch das ausgekoppelte Ausgangssignal I des Differenzverstärkers 14 überschritten wird. Der den zweiten Schwellenwert SW2 überschreitende Teil des Ausgangssignals I des Differenzverstärkers 14 wird von der Dämpfung 46 in einem Maße gedämpft, das eine stabile innere Rückführung gewährleistet. Das gedämpfte Signal wird als Rückführsignal Ifb_i der inneren Rückführung über die Auskoppelschaltung 48 an den Rückführsignaleingang 18 des Differenzverstärkers 14 angelegt.

Da der in der inneren Rückführung wirkende zweite Schwellenwert SW2 niedriger ist als der in der äußeren Rückführung wirkende erste Schwellenwert SW1, stellt sich bei geschlossenem Schalter 40, also im Abgleichmodus, zunächst ein größeres Rückführsignal Ifb_i am Rückführsignaleingang 18 des Differenzverstärkers 14 ein. Dadurch sinkt die Eingangssignaldifferenz am Differenzverstärker 14 und folglich auch die Stärke des Ausgangssignals I, die mit der Eingangssignaldifferenz über die Verstärkung G verknüpft ist. Bei entsprechender Dimensionierung des zweiten Schwellenwertes SW2 im Vergleich zu dem ersten Schwellenwert SW1 sinkt dann das Eingangssignal I' der Laserdiode 12 unter deren Laserschwelle ab, so dass die von der Laserdiode 12 abgestrahlte Lichtleistung zusammenbricht. Als Folge bricht auch die optische Kopplung zwischen Laserdiode 12 und Fotodiode 24 zusammen, so dass die äußere Rückführung, die im Betriebsmodus über diese optische Kopplung geschlossen wird, deaktiviert ist.

Ergänzend zum Deaktivieren der äußeren Rückführung über das Schließen des Schalters 40 erfolgt im Abgleichmodus ein Abschalten des Referenzsignalgenerators 20, so dass dieser kein Signal mehr an den Referenzsignaleingang 16 des Differenzverstärkers 14 liefert. Wenn die Kennlinie des Differenzverstärkers 14 der idealen Kennlinie 28 aus der Figur 3 entspricht, wird dann auch das Ausgangssignal I des Differenzverstärkers 14 auf den Wert null zurückgehen und die Eingangssignaldifferenz zwischen den Eingängen 16 und 18 des Differenzverstärkers 14 wird verschwinden.

Besitzt der Differenzverstärker 14 dagegen die durch einen positiven Offsetstrom nach links verschobene Kennlinie 32 aus der Figur 3, so wird sich auch bei abgeschaltetem Referenzsignal ein Ausgangssignal I einstellen, das über die innere Rückführung als gedämpftes Signal Ifb_i an den Rückführsignaleingang 18 des Differenzverstärkers 14 zurückgeführt wird. Über eine Adaptionsschaltung, die im Wesentlichen aus dem Detektor 50, der Steuerung 22, der Kompensationsstromquelle 52 und der Verknüpfung 54 und/oder der Verknüpfung 55 besteht, kann dieser unerwünschte Offset im Abgleichmodus gelernt werden und im nachfolgenden Betriebsmodus kompensiert werden. Die Auskoppelschaltung 48 koppelt ein Signal aus der inneren Rückführung aus, in dem sich das Rückführsignal Ifb_i abbildet. Die Abbildung kann bspw. identisch sein, so dass ein Signal Ifb_i in den Detektor 50 der Adaptionsschaltung eingespeist wird.

Der Detektor 50 vergleicht das eingespeiste Rückführsignal Ifb_i mit einem vorgegebenen dritten Schwellenwert SW3 und liefert bei Überschreitung oder Unterschreitung des dritten Schwellenwertes SW3 ein entsprechendes Signal an die Steuerung 22. Über die gestrichelte Verbindung zwischen den Blöcken 22 und 50 steuert die Steuerung 22 den Detektor 50 bspw. so, dass der Detektor 50 in einem durch die Steuerung 22 vorgegebenen Zeittakt sein Eingangssignal abtastet und mit dem dritten Schwellenwert SW3 vergleicht. Der dritte Schwellenwert SW3 kann bspw. so bemessen sein, dass er in der Auftragung der Figur 3 dem Wert f(SW3) entspricht. Dabei ist der Wert f(SW3) in der Figur 3 aus Gründen der Unterscheidbarkeit relativ hoch auf der I-Achse eingezeichnet und wird bei Realisierungen der Erfindung noch näher an den Koordinatenursprung herangeführt.

Wenn der dritte Schwellenwert SW3 gleich zu Beginn überschritten wird, wie es im Fall der Kennlinie 32 aus Figur 3 der Fall ist, löst die Steuerung 22 über die Kompensationsstromquelle 52 eine schrittweise Veränderung eines Kompensationsstroms aus, der über die Verknüpfung 54 an den Referenzsignaleingang 16 und/oder über die Verknüpfung 55 an den Rückführsignaleingang 18 des Differenzverstärkers 14 angelegt wird und den dort wirksamen Offsetstrom kompensieren soll. Um die Wirkung eines positiven (negativen) Kompensationsstroms am Referenzsignaleingang 16 zu erzielen, muss eine Einspeisung in den Rückführsignaleingang 18 mit negativem (positivem) Vorzeichen erfolgen. Wie bereits erwähnt, entspricht die Kennlinie 32 einem positiven Offsetstrom, so dass die Steuerung 22 in diesem Fall einen negativen Kompensationsstrom der Kompensationsstromquelle 52 einstellt, wenn der Kompensationsstrom über den Referenzsignaleingang eingespeist wird. Über die innere Rückführung bildet sich dies in einer Veränderung des Rückführsignals Ifb_i ab.

Im Fall der Kennlinie 32 aus der Figur 3 bewirkt das Einprägen eines negativen Kompensationsstroms in die Verknüpfung 54 eine Verschiebung der Kennlinie 32 nach rechts. Dadurch sinkt der Schnittpunkt der Kennlinie 32 mit der I-Achse ab. Bei wiederholtem Erhöhen des negativen Kompensationsstroms durch die Adaptionsschaltung rutscht die Kennlinie 32 sukzessive weiter nach unten, bis der Wert f(SW3) unterschritten wird. Dieses Unterschreiten wird von dem Detektor 50 detektiert und von der Steuerung 22 registriert. Die Steuerung 22 befiehlt der Kompensationsstromquelle 52 dann, den zuletzt verwendeten Kompensationsstromwert festzuhalten und im späteren Betriebsmodus mit aktivierter äußerer Rückführung zu verwenden.

Auf analoge Weise wird eine anfänglich durch einen negativen Offsetstrom nach rechts verschobene Kennlinie 30 in der Figur 3 durch sukzessives Ermitteln eines kompensierenden positiven Kompensationsstroms in den Koordinatenursprung verschoben.

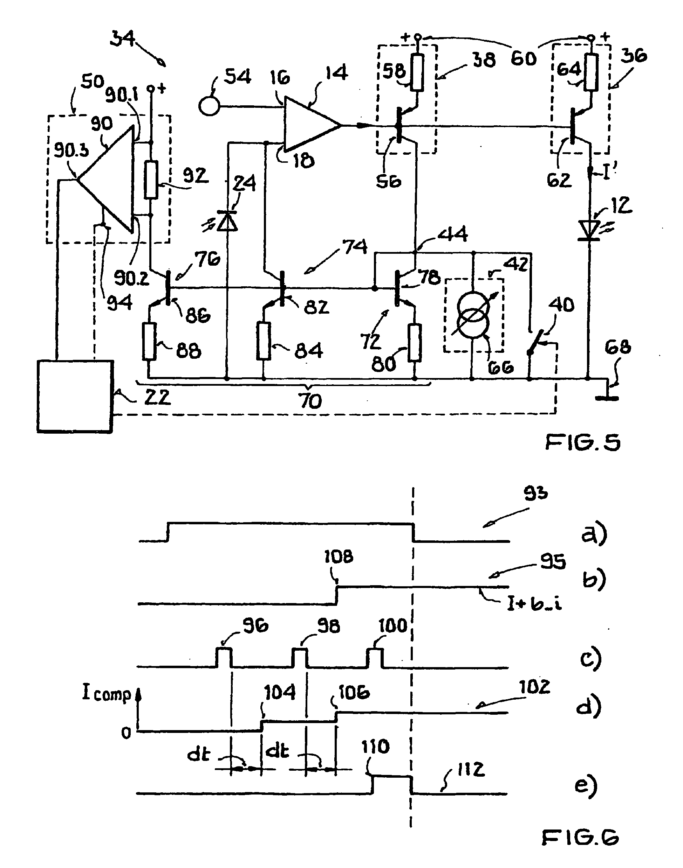

Figur 5 zeigt einen Schaltplan als Beispiel möglicher schaltungstechnischer Realisierungen verschiedener Blöcke aus der Figur 4. So kann die Auskopplung 38 durch einen Transistor 56 erfolgen, der über einen Emitterwiderstand 58 an ein Versorgungspotential 60 angeschlossen ist, der durch das Ausgangssignal des Differenzverstärkers 14 gesteuert wird, und dessen Kollektor mit der Schwellenwertverknüpfung 44 verbunden ist. Bei der Schaltung 34 nach Fig. 5 kann es sich bei dem Ausgangssignal des Differenzverstärkers um eine Spannung oder einen Strom handeln. Die Ausgangsstufe 36 kann ebenfalls durch einen Transistor 62 realisiert sein, der über einen Emitterwiderstand 64 an das Versorgungspotential 60 angeschlossen wird, der ebenfalls durch das Ausgangssignal I des Differenzverstärkers 14 gesteuert wird, und dessen Kollektorstrom als Eingangssignal I' der Laserdiode 12 dient. Das Schwellenwertfilter 42 kann bspw. aus einer variablen Stromquelle 66 bestehen, die einen Strom variabler Stärke, aber vorgegebener Maximalstärke von der Schwellenwertverknüpfung 44 zieht und die zwischen der Schwellenwertverknüpfung 44 und einem Massepotentialanschluss 68 liegt.

Ein Stromspiegel 70, der drei Zweige 72, 74 und 76 aufweist, spiegelt einen im ersten Zweig 72 von der Schwellenwertverknüpfung 44 über einen Transistor 78 und einen Widerstand 80 zum Massepotential 68 fließenden Strom als Rückführstrom Ifb_i in die anderen beiden Zweige 74 und 76, die ebenfalls je einen Transistor 82, 86 und Emitterwiderstand 84, 88 aufweisen. Der Kollektor des Transistors 82 des zweiten Zweiges 74 ist mit dem Rückführsignaleingang 18 des Differenzverstärkers 14 verbunden und schließt damit die innere Rückführung. Der Schalter 40 dient wie im Fall der Fig. 4 zur Deaktivierung der äußeren Rückführung. Allerdings ist er in der Fig. 5 im Unterschied zur Fig. 4 so angeordnet, dass er die äußere Rückführung im geschlossenen Zustand deaktiviert.

Die in der Figur 4 als Block 46 dargestellte Dämpfung ergibt sich bei der Realisierung der Figur 5 durch das Übersetzungsverhältnis der Ströme in den Zweigen 72 und 74. Der in den dritten Zweig 76 gespiegelte Strom stellt einen aus der inneren Rückführung ausgekoppelten Strom dar, so dass der dritte Zweig 76 in Verbindung mit den beiden anderen Zweigen 72, 74 des Stromspiegels 70 die Funktion der Auskoppelschaltung 48 aus der Figur 4 repräsentiert. Dabei können die Transistoren und Widerstände so dimensioniert werden, dass in den Messzweig 76 ein anderer Strom eingespeist wird als in den Rückführzweig 74. Durch einen höheren Strom im Messzweig 76 kann zum Beispiel der Spannungsabfall über einem Messwiderstand 92 vergrößert werden, was die Empfindlichkeit der Messung steigert. Der Detektor 50 aus der Figur 4 wird z. B. durch einen Komparator 90 in Verbindung mit dem Messwiderstand 92 realisiert. Der Komparator 90 kann als "Latched Comparator" oder "getakteter Komparator" ausgeführt sein. Ein solcher getakteter Komparator besitzt zusätzlich zu Differenzeingängen 90.1 und 90.2 einen Takteingang 94. Mit dem eingeschalteten Taktsignal wird eine positive Rückkopplung innerhalb des Komparators 90 aktiviert, die den Zustand am Ausgang 90.3 des Komparators 90 festhält. Dieser ist dann, d.h. bis zum nächsten Impuls des Taktsignals, unabhängig vom Eingangssignal. Durch die positive Rückkopplung wird die Verstärkung des Komparators 90 im Umschaltzeitpunkt sehr groß, so dass bereits kleinste Änderungen zwischen den Differenzeingängen 90.1 und 90.2 zu eindeutigen Signalen am Ausgang 90.3 führen.

Figur 6 zeigt zeitliche Verläufe von Signalen, wie sie an verschiedenen Stellen der Schaltungen nach den Figuren 4 und 5 abnehmbar sind, wenn der Differenzverstärker 14 die um einen negativen Offsetstrom nach rechts verschobene Kennlinie 30 aus der Figur 3 aufweist. Der hohe Pegel des Signals 93 in der Figur 6a repräsentiert einen aktiven Abgleichmodus, während der niedrige Signalpegel dort einen aktiven Betriebsmodus repräsentiert. Wie aus der Figur 3 ersichtlich ist, stellt sich im Fall der Kennlinie 30 als Ausgangssignal I des Differenzverstärkers 14 ein Nullsignal, beziehungsweise ein Signal ein, das kleiner als der Wert f(SW3) in der Figur 3 ist. Daher fließt auch zunächst in der inneren Rückführung kein Strom, so dass auch das Rückführsignal Ifb_i zunächst null ist. Dies wird durch den anfänglich niedrigen Signalpegel in der Figur 6b repräsentiert, die den zeitlichen Verlauf 95 des Signals Ifb_i repräsentiert.

Figur 6c verdeutlicht die Abtastung des Rückführsignals Ifb_i durch den Detektor 50. Dabei entsprechen die Impulse 96, 98 und 100 jeweils Zeitspannen, in denen die Steuerung 22 ein Taktsignal an den Takteingang 94 des Komparators 90 in der Figur 5 anlegt und damit einen Messwert aufnimmt. Figur 6d verdeutlicht einen möglichen Verlauf 102 eines Kompensationsstroms Icomp. Anfänglich, d. h. bei der ersten Messung durch den Impuls 96, ist der Kompensationswert noch null. Da der Detektor 50 bei der ersten Messung feststellt, dass das Rückführsignal Ifb_i unterhalb des dritten Schwellenwertes SW3 liegt, stellt die Steuerung 22 über die Kompensationsstromquelle 52 einen ersten Basiswert eines positiven Kompensationsstromes ein, wobei die Einstellung in der Fig. 6 jeweils mit einer Verzögerung dt erfolgt. Dieser Basiswert entspricht der ersten Stufe 104 im Signal 102. Im Ergebnis wird dadurch die Kennlinie 30 aus Figur 3 etwas nach rechts in Richtung auf den Koordinatenursprung verschoben.

Wenn die Verschiebung noch nicht dazu ausreicht, dass die Kennlinie 30 oberhalb des Schwellenwertes f(SW3) liegt, war der Basiswert des eingestellten Kompensationsstroms offensichtlich zu klein und der Detektor 50 stellt beim nächsten Messimpuls 98 wieder fest, dass das Rückführsignal Ifb_i unterhalb des dritten Schwellenwertes SW3 liegt. Als Folge erhöht die Steuerung 22 mit Hilfe der Kompensationsstromquelle 52 den Kompensationsstrom um eine vorgegebene Schrittweite, die in der Figur 6d der Stufenhöhe beim Übergang von der Stufe 104 zur Stufe 106 entspricht. Für das Folgende wird angenommen, dass der Kompensationsstrom jetzt so groß ist, dass er den negativen Offsetstrom überkompensiert. Dies bedeutet im Bild der Figur 3, dass die Kennlinie 30 so weit nach links verschoben worden ist, dass der Schwellenwert f(SW3) jetzt unterhalb der verschobenen Kennlinie 30 liegt.

Dann tritt bei immer noch abgeschaltetem Referenzsignalgenerator 20 ein Ausgangssignal I am Ausgang des Differenzverstärkers 14 auf, das sich in einer Erhöhung des Rückführsignals Ifb_i abbildet. Dies ist in der Figur 6b durch die Stufe 108 im Signalverlauf 95 dargestellt. Unter der genannten Annahme wird Ifb_i so groß sein, dass der Detektor 50 bei seinem nächsten Abtastimpuls 100 eine Überschreitung des dritten Schwellenwertes SW3 feststellt. Er signalisiert das mit einem Umschalten auf einen hohen Signalpegel 110 im Signal 112, das über den geschlossenen Schalter 94 in die Steuerung 22 eingespeist wird. Die Steuerung 22 registriert also die Überschreitung des dritten Schwellenwertes SW3 und beendet den Abgleichmodus, was durch die fallende Flanke im Signal 93 der Figur 6a repräsentiert wird. Gleichzeitig hält die Kompensationsstromquelle 52 den ermittelten Kompensationsstromwert fest. In einem nachfolgenden Betriebsmodus wird dadurch immer näherungsweise mit der idealen Kennlinie 28 aus der Figur 3 gearbeitet.

## Patentansprüche

1. Treiberschaltung (34), die in einem Betriebsmodus (12) ein Bauteil treibt, das nur dann eine Ausgangsleistung liefert, wenn ein treibendes Eingangssignal einen ersten Schwellenwert übersteigt, mit einem Differenzverstärker (14), dessen Ausgangssignal das treibende Eingangssignal steuert, einem Referenzsignalgenerator (20), der einen Referenzsignaleingang (16) des Differenzverstärkers speist, und mit einer äußeren Rückführung, die ein vom Ausgangssignal abhängiges Signal an einen Rückführsignaleingang (18) des Differenzverstärkers (14) legt, **dadurch gekennzeichnet, dass** die Treiberschaltung (34) eine Adaptionsschaltung (50, 22, 52, 54) und eine in einem Abgleichmodus alternativ zur äußeren Rückführung aktivierbare innere Rückführung (42, 44, 46, 48) aufweist, die bereits bei Eingangssignalen, die den ersten Schwellenwert nicht überschreiten, ein Signal sowohl an den Rückführsignaleingang (18) als auch an die Adaptionsschaltung (50, 22, 52, 54) liefert, die Adaptionsschaltung (50, 22, 52, 54) aus dem Signal ein Kompensationssignal bildet und speichert, das ein am Referenzeingang (16) bei abgeschaltetem Referenzsignalgenerator (20) allein wirksames Offsetsignal kompensiert, und die Adaptionsschaltung (50, 22, 52, 54) das gespeicherte Kompensationssignal bei aktivierter äußerer Rückführung zusätzlich zu einem vom Referenzsignalgenerator (20) gelieferten Referenzsignal in den Referenzeingang (16), oder den Rückführsignaleingang (18) einspeist.

2. Treiberschaltung (34) nach Anspruch 1, **dadurch gekennzeichnet, dass** die innere Rückführung (42, 44, 46, 48) einen Schwellenwertfilter (42) aufweist, das nur Rückführsignale passieren lässt, die einen zweiten Schwellenwert überschreiten.

3. Treiberschaltung (34) nach Anspruch 2, **gekennzeichnet durch** eine Realisierung des Schwellenwertfilters (42) als mit der inneren Rückführung (42, 44, 46, 48) verbundene Stromquelle (66), die einen Strom bis zu einer vorbestimmten, dem zweiten Schwellenwert entsprechenden maximalen Stromstärke aufnimmt oder ausgibt.

4. Treiberschaltung (34) nach Anspruch 1 oder 2, **dadurch gekennzeichnet, dass** die innere Rückführung eine Auskoppelschaltung (48) aufweist, die ein Rückführsignal aus der inneren Rückfiihrung (42, 44, 46, 48) auskoppelt und der Adaptionsschaltung (50, 22, 52, 54) zuführt.

5. Treiberschaltung (34) nach Anspruch 4, **dadurch gekennzeichnet, dass** die Auskoppelschaltung (48) einen Stromspiegel (70) aufweist, der einen aus dem Differenzverstärker (14) in die innere Rückführung (42, 44, 46, 48) eingespeisten Strom sowohl in einen zum Rückführsignaleingang (18) führenden Stromzweig (74) als auch in einen Messzweig (76) der Adaptionsschaltung (50, 22, 52, 54) abbildet.

6. Treiberschaltung (34) nach wenigstens einem der vorhergehenden Ansprüche, **dadurch gekennzeichnet, dass** die Adaptionsschaltung (50, 22, 52, 54) einen Detektor (50) aufweist, der eine Signalstärke des ausgekoppelten Rückführsignals erfasst und an eine Steuerung (22) übergibt.

7. Treiberschaltung (34) nach Anspruch 5, **dadurch gekennzeichnet, dass** der Detektor (50) die Signalstärke periodisch abtastet.

8. Treiberschaltung (34) nach Anspruch 7, **dadurch gekennzeichnet, dass** der Detektor (50) als getakteter Komparator (90) ausgeführt ist.

9. Treiberschaltung (34) nach Anspruch 5 oder 6, **dadurch gekennzeichnet, dass** die Steuerung (22) die Signalstärke speichert und über Ansteuerung einer Kompensationsstromquelle (52) einen Kompensationsstrom an dem Referenzeingang (16) oder dem Rückführsignaleingang (18) erzeugt, der den Offsetstrom wenigstens teilweise kompensiert.

10. Verfahren zur Kompensation von Offsetströmen in einer Treiberschaltung (34), die in einem Betriebsmodus ein Bauteil (12) treibt, das nur dann eine Ausgangsleistung liefert, wenn ein treibendes Eingangssignal einen ersten Schwellenwert übersteigt, und die aufweist: einen Differenzverstärker (14), dessen Ausgangssignal das treibende Eingangssignal steuert, einen Referenzsignalgenerator (20), der einen Referenzsignaleingang (16) des Differenzverstärkers (14) speist, und eine äußere Rückführung, die ein vom Ausgangssignal abhängiges Signal an einen Rückführsignaleingang (18) des Differenzverstärkers (14) legt, **dadurch gekennzeichnet, dass** das Verfahren die folgenden Schritte aufweist: Aktivieren einer alternativ zur äußeren Rückführung aktivierbaren inneren Rückführung (42, 44, 46, 48), die bereits bei Eingangssignalen, die den ersten Schwellenwert nicht überschreiten, ein Signal sowohl an den Rückführsignaleingang (18) als auch an die Adaptionsschaltung (50, 22, 52, 54) liefert, Speichern eines aus dem Signal gebildeten Kompensationssignals, das ein am Referenzeingang (16) bei abgeschaltetem Referenzsignalgenerator (20) allein wirksames Offsetsignal kompensiert, und, bei aktivierter äußerer Rückführung, zusätzlich zur Einspeisung eines vom Referenzsignalgenerator (20) gelieferten Referenzsignals erfolgendes Einspeisen des gespeicherten Kompensationssignal in den Referenzeingang (16), oder den Rückführsignaleingang (18) .

11. Verfahren nach Anspruch 10, **dadurch gekennzeichnet, dass** eine Bildung des Kompensationssignals schrittweise erfolgt, wobei das an die Adaptionsschaltung (42, 44, 46, 48) gelieferte Signal mit einem dritten Schwellenwert verglichen wird und wobei das Kompensationssignal von einem Startwert an schrittweise verändert wird, bis das an die Adaptionsschaltung (42, 44, 46, 48) gelieferte Signal den dritten Schwellenwert durchläuft.

## Claims

1. Driver circuit (34) which in an operating mode (12) drives a component which supplies an output power only when a driving input signal exceeds a first threshold value, with a differential amplifier (14), the output signal of which controls the driving input signal, a reference signal generator (20), which supplies a reference signal input (16) of the differential amplifier, and with an external feedback which applies a signal, which is dependent on the output signal, to a feedback signal input (18) of the differential amplifier (14), **characterised in that** the driver circuit (34) comprises an adaptation circuit (50, 22, 52, 54) and an internal feedback (42, 44, 46, 48), which in a balancing mode is activatable alternatively to the external feedback and which supplies a signal not only to the feedback signal input (18), but also to the adaptation circuit (50, 22, 52, 54) already in the case of input signals not exceeding the first threshold value, the adaptation circuit (50, 22, 52, 54) forms from the signal, and stores, a compensation signal which provides compensation for an offset signal solely effective at the reference input (16) when the reference signal generator (20) is switched off and the adaptation circuit (50, 22, 52, 54) supplies to the reference input (16) or the feedback signal input (18) the stored compensation signal, when the external feedback is activated, additionally to a reference signal delivered by a reference signal generator (20).

2. Driver circuit (34) according to claim 1, **characterised in that** the internal feedback (42, 44, 46, 48) has a threshold value filter (42) which allows only feedback signals, which exceed a second threshold value, to pass.

3. Driver circuit (34) according to claim 2, **characterised by** a realisation of the threshold value filter (42) as a power source (66) which is connected with the internal feedback (42, 44, 46, 48) and which receives or delivers a current up to a predetermined maximum current strength corresponding with the second threshold value.

4. Driver circuit (34) according to claim 1 or 2, **characterised in that** internal feedback comprises a decoupling circuit (48) which decouples a feedback signal from the internal feedback (42, 44, 46, 48) and feeds to the adaptation circuit (50, 22, 52, 54).

5. Driver circuit (34) according to claim 4, **characterised in that** the decoupling circuit (48) has a current mirror (70) which images a current, which is supplied from a differential amplifier (14) to the internal feedback (42, 44, 46, 48), not only to a current branch (74) leading to the feedback signal input (18), but also to a measuring branch (76) of the adaptation circuit (50, 22, 52, 54).

6. Driver circuit (34) according to at least one of the preceding claims, **characterised in that** the adaptation circuit (50, 22, 52, 54) comprises a detector (50) which detects a signal strength of the decoupled feedback signal and transfers it to a control (22).

7. Driver circuit (34) according to claim 5, **characterised in that** the detector (50) periodically senses the signal strength.

8. Driver circuit (34) according to claim 7, **characterised in that** the detector (50) is constructed as a cyclically operated comparator (90).

9. Driver circuit (34) according to claim 5 or 6, **characterised in that** the control (22) stores the signal strength and produces by way of drive control of a compensation current source (52) a compensation current at the reference input (16) or the feedback signal input (18), which provides at least partial compensation for the offset current.

10. Method of compensating for offset currents in a driver circuit (34), which in an operating mode drives a component (12) which delivers an output power only when a driving input signal exceeds a first threshold value, and which comprises: a differential amplifier (14), the output signal of which controls the driving input signal, a reference signal generator (20), which supplies a reference signal input (16) of the differential amplifier (14), and an external feedback which applies to a feedback signal input (18) of the differential amplifier (14) a signal dependent on the output signal, **characterised in that** the method comprises the following steps: activating an internal feedback (42, 44, 46, 48), which is activatable alternatively to the external feedback and which supplies a signal not only to the feedback signal input (18), but also to the adaptation circuit (50, 22, 52, 54) already in the case of input signals not exceeding the first threshold value, storing a compensation signal, which is formed from the signal and which provides compensation for an offset signal solely effective at the reference input (16) when the reference signal generator (20) is switched off and supplying the stored compensation signal to the reference input (16) or the feedback signal input (18), when the external feedback is activated, additionally to the supply of a reference signal delivered by the reference signal generator (20).

11. Method according to claim 10, **characterised in that** a formation of the compensation signal takes place in steps, wherein the signal supplied to the adaptation circuit (42, 44, 46, 48) is compared with a third threshold value and wherein the compensation signal is changed in steps from a starting value until the signal supplied to the adaptation circuit (42, 44, 46, 48) runs through the third threshold value.

## Revendications

1. Circuit d'excitation (34) qui dans un mode de fonctionnement excite un composant (12) ne fournissant une puissance de sortie que lorsqu'un signal d'excitation d'entrée dépasse une première valeur de seuil, circuit comprenant un amplificateur différentiel (14) dont le signal de sortie commande le signal d'excitation d'entrée, un générateur de signal de référence (20) qui alimente une entrée de signal de référence (16) de l'amplificateur différentiel, et une boucle extérieure de réaction qui applique un signal dépendant du signal de sortie à une entrée de signal de réaction (18) de l'amplificateur différentiel (14), **caractérisé en ce que** le circuit d'excitation (34) comporte un circuit d'adaptation (50,22,52,54) et une boucle interne de réaction (42,44,46,48) activable dans un mode d'équilibrage en remplacement de la boucle extérieure de réaction et qui fournit un signal aussi bien à l'entrée de signal de réaction (18) qu'au circuit d'adaptation (50,22,52,54) dès l'existence de signaux d'entrée ne dépassant pas la première valeur de seuil, **en ce que** le circuit d'adaptation (50,22,52,54) forme et mémorise, à partir de ce signal, un signal de compensation qui compense un signal de décalage agissant seul sur l'entrée de référence (16) lorsque le générateur de signal de référence (20) est coupé, et **en ce que** le circuit d'adaptation (50,22,52,54) introduit dans l'entrée de référence (16) ou l'entrée de signal de réaction (18) le signal de compensation mémorisé, en plus d'un signal de référence fourni par le générateur de signal de référence (20) lorsque la boucle extérieure de réaction est activé.

2. Circuit d'excitation (34) selon la revendication 1, **caractérisé en ce que** la boucle interne de réaction (42,44,46,48) présente un filtre à seuil (42) qui ne laisse passer que des signaux de réaction dépassant une deuxième valeur de seuil.

3. Circuit d'excitation (34) selon la revendication 2, **caractérisé par** une forme de réalisation du filtre à seuil (42) en source de courant (66) en liaison avec la boucle interne de réaction (42,44,46,48) qui reçoit ou envoie un courant jusqu'à une intensité maximale prédéfinie de courant correspondant à la deuxième valeur de seuil.

4. Circuit d'excitation (34) selon la revendication 1 ou 2, **caractérisé en ce que** la boucle interne de réaction présente un circuit de découplage (48) qui découple un signal de réaction à partir de la boucle interne de réaction (42,44,46,48) et l'achemine vers le circuit d'adaptation (50,22,52,54).

5. Circuit d'excitation (34) selon la revendication 4, **caractérisé en ce que** le circuit de découplage (48) présente un miroir de courant (70) qui reproduit un courant introduit dans la boucle interne de réaction (42,44,46,48) à partir de l'amplificateur différentiel (14) aussi bien dans une branche de courant (74) conduisant à l'entrée du signal de réaction (18) que dans une branche de mesure (76) du circuit d'adaptation (50,22,52,54).

6. Circuit d'excitation (34) selon l'une au moins des revendications précédentes, **caractérisé en ce que** le circuit d'adaptation (50,22,52,54) présente un détecteur (50) qui détecte une intensité de signal du signal de réaction découplé et la transmet à un système de commande (22).

7. Circuit d'excitation (34) selon la revendication 5, **caractérisé en ce que** le détecteur (50) analyse périodiquement l'intensité de signal.

8. Circuit d'excitation (34) selon la revendication 7, **caractérisé en ce que** le détecteur est réalisé sous la forme d'un comparateur (90) cadencé.

9. Circuit d'excitation (34) selon la revendication 5 ou 6, **caractérisé en ce que** le système de commande (22) mémorise l'intensité de signal et génère, par excitation d'une source de courant de compensation (52), un courant de compensation à l'entrée de référence (16) ou à l'entrée du signal de réaction (18) qui compense au moins partiellement le courant de décalage.

10. Procédé de compensation de courants de décalage dans un circuit d'excitation (34) qui dans un mode de fonctionnement excite un composant (12) ne fournissant une puissance de sortie que lorsqu'un signal d'excitation d'entrée dépasse une première valeur de seuil, circuit comprenant : un amplificateur différentiel (14) dont le signal de sortie commande le signal d'excitation d'entrée, un générateur de signal de référence (20) qui alimente une entrée de signal de référence (16) de l'amplificateur différentiel (14), et une boucle extérieure de réaction qui applique un signal dépendant du signal de sortie à une entrée de signal de réaction (18) de l'amplificateur différentiel (14), **caractérisé en ce que** le procédé comporte les étapes suivantes: activation d'une boucle interne de réaction (42,44,46,48) qui peut être activée en remplacement de la boucle extérieure de réaction, boucle interne qui fournit un signal aussi bien à l'entrée de signal de réaction (18) qu'au circuit d'adaptation (50,22,52,54) dès l'existence de signaux d'entrée ne dépassant pas la première valeur de seuil, mémorisation, à partir de ce signal, d'un signal de compensation qui compense un signal de décalage agissant seul sur l'entrée de référence (16) lorsque le générateur de signal de référence (20) est coupé, et, lorsque la boucle extérieure de réaction est activée, introduction supplémentaire, dans l'entrée de référence (16) ou l'entrée de signal de réaction (18), du signal de compensation mémorisé, en vue de l'introduction d'un signal de référence fourni par le générateur de signal de référence (20).

11. Procédé selon la revendication 10, **caractérisé en ce que** la génération du signal de compensation s'effectue de manière incrémentielle, procédé dans lequel on compare le signal fourni au circuit d'adaptation (50,22,52,54) à une troisième valeur de seuil et dans lequel le signal de compensation est modifié de manière incrémentielle à partir d'une valeur de départ jusqu'à ce que le signal fourni au circuit d'adaptation (50,22,52,54) parcoure la troisième valeur de seuil.
